Europäisches Patentamt

European Patent Office

Office européen des brevets

(19)

(11) Publication number: **0 050 986**
**A2**

# (12) EUROPEAN PATENT APPLICATION

(21) Application number: **81305051.5**

(22) Date of filing: **26.10.81**

(51) Int. Cl.³: **G 06 F 11/26**

(30) Priority: **27.10.80 GB 8034465**

(43) Date of publication of application:
**05.05.82 Bulletin 82/18**

(84) Designated Contracting States:
**BE DE FR GB IT LU NL**

(71) Applicant: **HAL Computers Limited**
**57 Woodham Lane New Haw**
**Weybridge Surrey, KT15 3NJ(GB)**

(72) Inventor: **Titherley, Robert Harold**
**57 Woodham Lane New Haw**
**Weybridge Surrey KT15 3NJ(GB)**

(74) Representative: **Godsill, John Kenneth et al,**
**Haseltine Lake & CO. Hazlitt House 28 Southampton**
**Buildings Chancery Lane**
**London WC2A 1AT(GB)**

(54) Computer peripheral testing equipment.

(57) Computer peripheral testing equipment comprises a portable microprocessor system (1) having a peripheral connector (6), a keyboard (3) and a display (4), in combination with plug-in modules (7) containing firmware defining keyboard functions, peripheral connector configurations and test and exercising routines and in combination with interfaces (8) containing line drivers to interface between said connector (6) and various peripherals.

FIG. 1.

EP 0 050 986 A2

2.

Conventional computer peripheral testing equipment normally involves the host computer or test means internally of the peripheral equipment or dedicated logic circuitry specific to only one type of peripheral. In the first case, test software is provided for the host computer which provides a sequence of tests normally under control of the user. Any defect in the host computer can affect results, so that this does not always provide a reliable test method. In the second case, interface circuitry in the peripheral will not normally be incorporated in the test so that a defect there will not be directly exposed. In the third case, there is lack of flexibility.

U.K. Patent Specification No. 1,356,324, for an Electronic Circuit Tester, discloses a special purpose electronic circuit tester comprising a programmable computer containing a test pattern. This is a chip tester to allow individual chips in a memory array to be tested. It is not designed for testing peripherals.

U.K. Patent Specification No. 1,328,978 discloses electronic unit testing equipment for use with a computer to provide a system for testing printed circuit

3.

cards by applying stimulus to a board in a manner controlled by the computer and by comparing the results with a stored norm. Computer peripherals as such do not in general seem to be catered for by this equipment. Thus, it not only suffers from the disadvantage mentioned above of requiring a host computer but also it seems not to be designed to test and exercise a variety of peripherals as such.

U.K. Patent Specification No. 1403710 discloses a general purpose computer which is not designed for peripheral testing as such but which can have self-diagnosis and, like other general computers, can be coupled to operate a variety of peripherals via respective dedicated input/output connectors.

The programming of the computer may be altered by changing plug-in program modules which can alter the functions of keys of a keyboard of the computer e.g. to give different typewriter functions. The computer, being general purpose, is somewhat expensive and unwieldy for use as an engineer's diagnostic tool and, indeed, is not designed as such.

It is an object of the invention to provide a self-contained, portable, engineer's diagnostic tool by which computer peripherals can be tested and exercised independently of their host computer.

## SUMMARY OF THE INVENTION

According to the invention, there is provided computer peripheral testing equipment comprising, in combination, (a) a self-contained, portable, special-purpose microprocessor system, (b) a plug-in firmware module for releasable plug-in connection with the system and containing firmware defining peripheral test and exercising routines, and (c) a plug-in input/output module, for releasably coupling a computer peripheral to said system, that is an interface circuit

4.

including line drivers, the system comprising: a first connector for receiving said input/output module and having a plurality of contacts for electrically contacting said input/output module; a keyboard; a microprocessor; a monitor; and a second connector for receiving said plug-in firmware module, the monitor comprising means for assigning functions to a first portion of the keyboard, and said firmware module comprising means for assigning functions to a further portion of the keyboard for use in the execution of the firmware testing and exercising routines and said firmware module also providing means for configuring contacts of the first connector such that some of said contacts provide for input and others for output, the functions of the keyboard, the configuration of the first connector and the form of testing and exercising being dependent upon said firmware module which can be interchanged to alter the purpose of the equipment.

The equipment is thus a dedicated computer enabling computer peripherals to be tested independently of their host computer by a hand-carried device which would form part of a maintenance engineer's equipment. By exchanging the plug-in modules a variety of peripherals can be tested by test and exercising routines particularly adapted to the peripheral concerned.

The or each plug-in firmware module will incorporate monitor routines defining keyboard functions so that operator intervention can be made specific to each module. Display means may be provided to display data defined by the monitor and the firmware to provide operator guidance during operation.

The firmware modules will also incorporate routines in order to configure the peripheral connector contacts according to the required functions for the operation concerned, e.g. configuring certain connections for output and leaving others configured for input.

A preferred embodiment is designed so as to make it as simple and as cheap as possible in the sense that many features of existing microprocessor systems which are irrelevant to peripheral testing and exercising are omitted. Thus, for example, no facilities are provided for programming the system _via_ the keyboard. All programming is contained in the monitor and in the plug-in test modules. It will be apparent that such portable microprocessor system is effectively inoperable as a computer system in the absence of the plug-in firmware module.

A preferred embodiment, therefore, consists in essence merely of: a microprocessor chip; a keyboard and display control chip; buffers for the plug-in firmware module; the monitor; and memory and input-output ports associated with the connector for the peripheral under test, these items all being interconnected by an address-data-control bus. Drivers between the bus and ports will be omitted as these are in the plug-in input/output module.

BRIEF DESCRIPTION OF THE DRAWINGS

For a better understanding of the invention and to show how the same may be carried into effect, reference will now be made, by way of example, to the accompanying drawings, in which:

Figure 1 is a perspective view of computer periperal test equipment;

Figure 2 is a schematic diagram of a microprocessor system incorporated in the test equipment; and

Figure 3 is a circuit diagram of an interface board.

DETAILED DESCRIPTION OF AN EMBODIMENT OF THE INVENTION

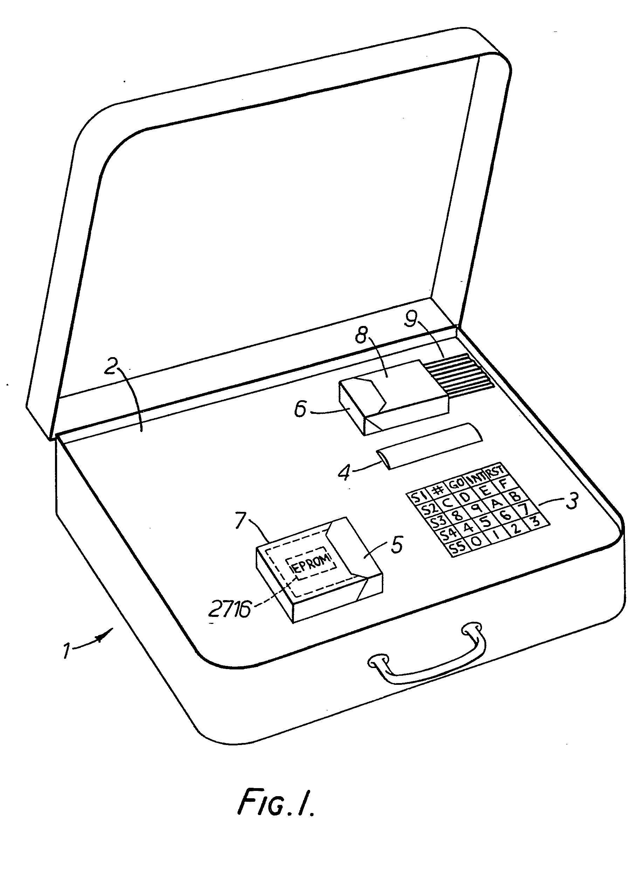

Figure 1 shows in perspective self-contained, special-purpose, computer peripheral test equipment which is contained in a portable case 1 supporting within it a front panel 2 below which is mounted a microprocessor system to be described hereinafter. The front panel 2 carries a keyboard 3 incorporating a hexadecimal set of keys together with nine further keys which are as follows: a ⌗-key which is a data entry or "return" key; a RST-key for reset purposes; an INT-key to implement an interrupt; a GO-key and five further variable function keys S1, S2, S3, S4 and S5.

The panel 2 also supports a display 4 and two printed circuit board connectors 5 and 6 which are mounted within the protective covers which are visible in Figure 1. A plug-in module 7 is releasably attached to the connector 5 as shown in Figure 1, and an interface module 8 is releasably attached to the connector 6. Extending from the interface module 8 is a strip connector 9 which extends to a peripheral under test (not shown).

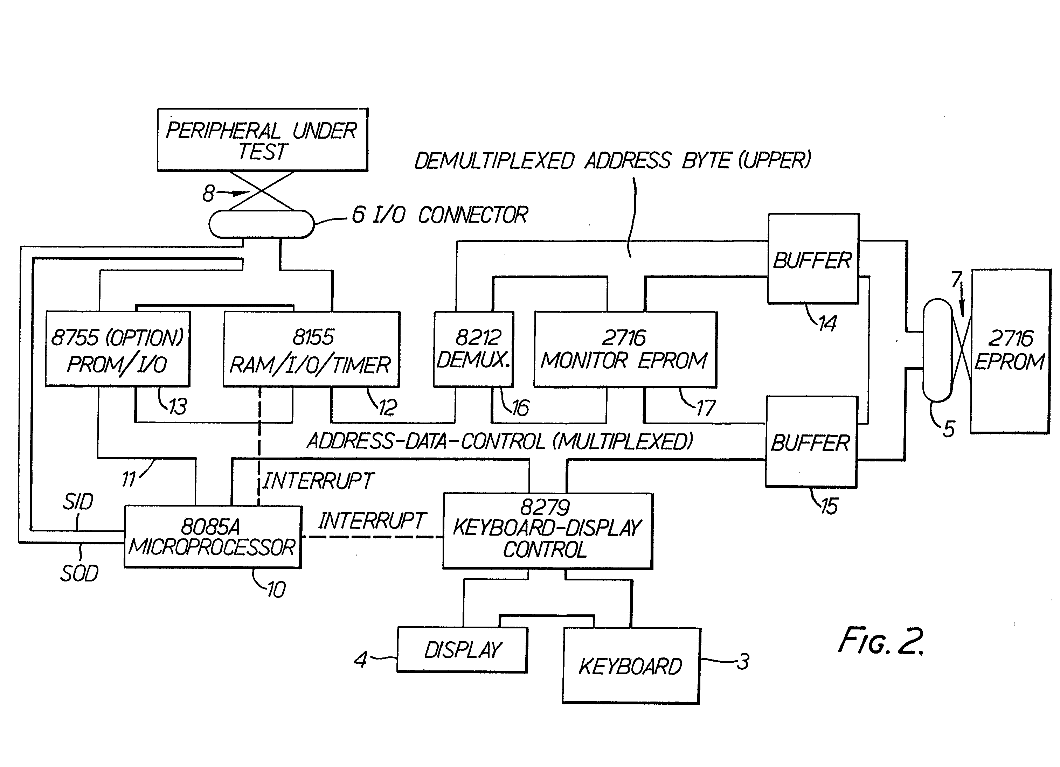

Figure 2 is a schematic block diagram of the microprocessor system and shows the items 3, 4, 5 and 6 already mentioned with reference to Figure 1. The microprocessor system has as its fundamental item a microprocessor chip of type 8085A which is an eight-bit processor using multiplexed address and data lines. This microprocessor chip is designated 10 in Figure 2. Extending from the microprocessor is an address-data-control bus 11. Serial input and output lines (SID and SOD) also extend from the microprocessor chip to the connector 6.

The connector 6 is otherwise connected to the microprocessor _via_ the bus 11 and an 8155 device 12 which is a static read-write memory with input/output ports and a timer. This device 12 acts as a buffer for the connector 6 and provides input and output ports therefor together with a timer for providing a timed interrupt at the TRAP input of the microprocessor.

Figure 2 shows additional input/output ports and memory for the connector 6 provided by a device 13 which is an 8755 chip, which is an erasable programmable read only memory with two 8-bit input/ output ports. Note that chips 12 and 13 are connected directly, without line drivers, to connector 6, so that chips 12 and 13 would not be able to drive most peripherals by themselves.

The connector 5 is connected to the microprocessor by way of the bus 11 together with buffers 14 and 15 (device 14 being provided by an 8212 chip which receives the upper address byte, and the buffer 15 being provided by a device 8212 for control signals on the control part of the bus and two bidirectional bus drivers of type 8216). The buffer 14 is coupled to the bus 11 by way of a demultiplexer circuit 16 of type 8212. Finally, Figure 2 shows the monitor itself which is an EPROM chip 17 of type 2716.

The details of the construction of such a system will be clear to those skilled in the art from this description of Figure 2, with reference to the book "An Introduction to Microcomputers" Volume 3 by Adam Osborne et al as published by Adam Osborne & Associates Incorporated. Chapter 5 of that book is particularly relevant to the preferred embodiment.

The plug-in module 7 is not shown in any further detail in the figures because it consists merely of the casing shown in Figure 1 which contains a printed circuit board having an edge provided with a series of contacts for the connector 5, these contacts being connected to the pins of an EPROM chip 2716 containing firmware incorporating monitor routines and either test and peripheral exercising routines or self-diagnostic routines for the equipment.

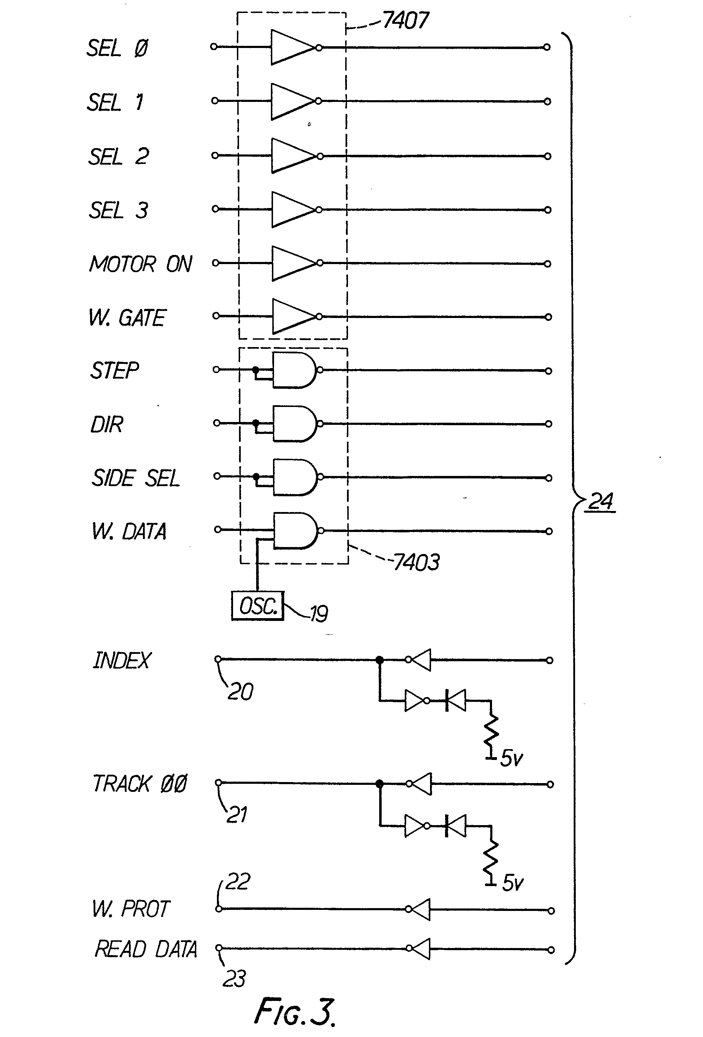

The interface module 8 similarly comprises a casing incorporating a printed circuit board provided with edge contacts for connection to the connector 6. Figure 3 shows an example of the circuitry of such an interface module, in this case adapted for connection to a 5¼ inch mini-floppy disc drive. The circuit of Figure 3 has ten inputs providing four track selection inputs, a motor-on input, a write gate input, a stepping input, a direction input, a side selection input, and a write data input. Nine of the ten inputs connect to inverters in the module whilst the write data input connects to a gate to which an oscillator 19 is also connected. Four outputs are provided from the circuit for supply to the microprocessor system _via_ amplifiers, these outputs being an index output 20, a track zero output 21, a write protect signal output 22 and a read-data output 23. Figure 3 also shows the connections 24 on one edge of the interface board which connect to the cable 9 shown in Figure 1.

The monitor 17 contains firmware which assigns functions to all the keys apart from S1 to S5 and which, on applying power to the system, configures the circuits 12 and 13 so that all their ports are defined as input ports. The monitor then provides a waiting state in which it is responsive only to the go-key. At this time the modules 7 and 8 should have been plugged into the respective connectors 5 and 6. When the go-key is actuated, the monitor causes the module 7 to be addressed to access an initialising routine which causes specific ports of the devices 12 and 13 to be reconfigured as output ports, leaving the remaining ports configured as input ports. Without module 7, the system is inoperable.

It will be assumed in the remainder of the description that the module 7 selected is one designed to test and exercise a 5¼ mini-floppy disc drive.

Having initialised the input and output ports, such a module will then provide a signal which will be directed to the connector 6 to start the disc drive motor. This is followed by a one second waiting period before the next routine is called.

The next routine accessed from the module causes, in this example, the display of the letters "tr" on a display to signify that the operator should input the number of tracks which the particular disc drive is intended for. This number will be input _via_ the hexadecimal keyboard and terminated by the # sign-key. A further routine from the module will then be accessed causing the display to change to the letters "St", awaiting an operator response which is the input of the step speed in milliseconds of the disc drive concerned. On receiving a valid input, the next-accessed routine from the module will be that displaying the letters "Prog" and causing the system to await the desired test program number, which in the present example may be 1, 2 or 3. When the number has been entered it is validated and appropriate routines are called from the module depending upon the selection, selection 1 initiating a general stepping test, 2 iniating a speed check and 3 initiating a continuous stepping exercising operation.

The general stepping operation will now be considered.

The first operation of the general stepping routine is to display "dr" in order to prompt the operator to input the required drive identification number, bearing in mind that several daisy-chained drives may be coupled to the test equipment. The next routine constitutes a test loop which continually monitors signals from the disc drive until it has ascertained that the drive selected is ready for testing with its head at track zero.

The drive status is then displayed on the display 4 and the system waits for operator actuation of keys S1 to S5.

The status is displayed by giving the drive number concerned, the track number, the side number and the status such as "R" for read, "E" for error and "P" for write protected. At this point keyboard monitor routines in the module 7 allocate specific functions to the keys S1 to S5.

In this example, actuation of key S1 will ask for the input of a specific track number and the drive will step to that track and then return to the routine which outputs the drive status and awaits a further key operation. Key S2 causes the drive to be recalibrated and will return to the initial state waiting for the go-key. Key S3 causes an output to initiate writing a "1F" pattern over the disc and will then return to the routine which outputs the drive status. Actuation of key S4 is similar to that of S3 except the pattern written is "2F". Key S5 provides an output to put the drive into a condition for reading data.

The second set of selectable program routines is one for speed checking and requires the operator to input the drive number. The selected drive then has its speed measured (index pulses from the drive are timed) and the display displays the highest and lowest values.

The third set of selectable routines provides for drive exercising by continuous stepping. The operator inputs the drive number and the starting and final tracks (which are displayed) and the module routines then continually step the drive back and forwards between the two tracks.

Other modules will provide similar routines for testing and exercising other periphals, such as printers and other types of drives .

The RST-key is scanned by the monitor and, on actuation, the system returns to its initial state by way of a hardware reset.

The INT-key initiates a jump to the previous input routine. Any data validation errors are displayed and key "C" will clear the error.

12.

Finally, it is to be noted that one form of firmware module 7 provides test and exercising routines for a Winchester-type disc drive. In order to provide for this type of drive, the interface module is designed to be connected, externally of the test equipment, to a power supply unit and controller for the disc drive. In this case, the power supply unit and controller are additional to the requirements for most peripherals.

13.

CLAIMS:

1. Computer peripheral testing equipment comprising a computer processor (10), a keyboard (3) for controlling the equipment, test routines operable by the processor, a monitor (17) defining functions at the keyboard (3), and a connector (6) for releasably coupling the processor to a peripheral to be tested, characterised in that the processor is a microprocessor (10) forming part of a self-contained, portable, special-purpose microprocessor system constituting the equipment, there being a plug-in firmware module (7) for releasable connection with the system and including means for assigning functions to a portion of the keyboard for use in the execution of peripheral exercising routines provided by the firmware module, the firmware module (7) also having means for configuring contacts of said connector (6) so that some of said contacts provide for input to and others for output from the equipment, and there also being an input/output interface (8), including line drivers (Figure 3), releasably coupled to the connector (6) for interfacing between the equipment and a peripheral, whereby, by changing the module and interface (8), the equipment can be adapted for exercising a range of peripherals.

2. Equipment as claimed in claim 1, and comprising a display (4) coupled to the microprocessor (19) for displaying data defined by the firmware module (7).

3. Equipment as claimed in claim 1 or 2, wherein the monitor (17) provides means for preparing the system for use on applying power to the system, and for preventing any further use of the system by an operator until an appropriate plug-in firmware module (7) is connected to the equipment.

4. Equipment as claimed in claim 1, 2 or 3, wherein the firmware module (7) comprises a read-only-

14.

memory (2716) containing said firmware.

5. Equipment as claimed in any one of the preceding claims, wherein the microprocessor (10) is connected to address, data and control conductors providing a bus (11) connected to: input/output ports (12, 13) connected to the connector (6); buffer means (14, 15) connected to a second connector (5) for the firmware module; and keyboard and display control means (8279).

6. Equipment as claimed in claim 5, and comprising memory (12) connected to said bus.

7. Computer peripheral test and exercising equipment comprising a protable case containing a microprocessor (10), an address and data bus (11) coupled to the microprocessor (10),a keyboard (3) coupled to said bus (11), a display (4) coupled to said bus (11), and a monitor (17), characterised by a first connector (6) coupled to the bus (11) and having contacts for releasable connection to an input/ output interface, a second connector (5) coupled to the bus (11) for releasably receiving a plug-in firmware module, and the monitor (17) having means for defining functions for only a part of the keyboard (3) and means for accessing data at said second connector (5) to configure contacts of said first connector (6), to define functions for a further part of the keyboard (3) and to define peripheral test and exercising routines, including provision for operating said display (4) to provide an indication of the progress of said routines.

8. Computer peripheral testing equipment substantially as hereinbefore described with reference to the accompanying drawings.

FIG.1.

PERIPHERAL UNDER TEST

8 →

6 I/O CONNECTOR

DEMULTIPLEXED ADDRESS BYTE (UPPER)

BUFFER — 14

8755 (OPTION) PROM/I/O — 13

8155 RAM/I/O/TIMER — 12

8212 DEMUX. — 16

2716 MONITOR EPROM — 17

7

2716 EPROM

5

ADDRESS-DATA-CONTROL (MULTIPLEXED)

BUFFER — 15

11

INTERRUPT

SID

8085A MICROPROCESSOR — 10

INTERRUPT

8279 KEYBOARD-DISPLAY CONTROL

SOD

4 — DISPLAY

KEYBOARD — 3

Fig. 2.

0050986

FIG.3.